# EUROPEAN PATENT APPLICATION

(11) **EP 2 799 399 A1**
(43) Date of publication of application: **05.11.2014**
(21) Application number: 12862311.3
(22) Date of filing: 30.11.2012
(51) Int. Cl.: C01G 19/00, H01L 31/04

(54) **CZTS-BASED COMPOUND SEMICONDUCTOR AND PHOTOELECTRIC TRANSDUCER**

(30) Priority: 28.12.2011 JP 2011288625
(71) Applicant: Toyota Jidosha Kabushiki Kaisha, Toyota-shi, Aichi 471-8571 (JP); Japan Fine Ceramics Center, Nagoya-shi, Aichi 456-8587 (JP)
(72) Inventor: SAKAI, Takenobu, Toyota-shi Aichi 471-8571 (JP); AWANO, Hiroki, Toyota-shi Aichi 471-8571 (JP); MAEKAWA, Ryosuke, Toyota-shi Aichi 471-8571 (JP); UEDA, Taro, Nagoya-shi Aichi 456-8587 (JP); TAKAHASHI, Seiji, Nagoya-shi Aichi 456-8587 (JP)
(74) Representative: TBK
(86) International application number: PCT/JP2012/081060
(87) International publication number: WO 2013/099517

(57) **Abstract**

A main object of the present invention is to provide a CZTS-based compound semiconductor whose band gap is different from that of a conventional CZTS-based compound semiconductor and a photoelectric conversion device prepared with the CZTS-based compound semiconductor. The present invention is a CZTS-based compound semiconductor in which a ratio of the number of moles of Cu to the total number of moles of Cu, Zn and Sn is larger than a ratio of the number of moles of Cu to the total number of moles of Cu, Zn and Sn configuring Cu₂ZnSnS₄, and a photoelectric conversion device prepared with the CZTS-based compound semiconductor.

## Description

### Technical Field

The present invention relates to a CZTS-based compound semiconductor and a photoelectric conversion device prepared with the CZTS-based compound semiconductor.

### Background Art

A solar cell has advantages that the amount of carbon dioxide emitted per power generation amount is small and it is not necessary to use fuel for power generation. Therefore, solar cells have been hoped as an energy source to inhibit global warming. Currently, among the solar cells in practical use, a mono-junction solar cell having a pair of p-n junction and using a single-crystal silicon or a polycrystal silicon has become a mainstream. Other than this, nowadays, studies on thin film solar cells and the like that do not depend on silicon have been actively developed.

A CZTS-based thin film solar cell is a solar battery in which Cu, Zn, Sn and S (hereinafter sometimes referred to as "CZTS-based material". Also, hereinafter, a compound semiconductor prepared with the CZTS-based material is referred to as "CZTS-based compound semiconductor".) are used for its light absorbing layer, instead of silicon. Since these are easily available and inexpensive, Cu, Zn, Sn and S are expected as materials of a light absorbing layer of thin film solar cells.

As a related art of the CZTS-based thin film solar cell, for example, Patent Document 1 discloses a sulfide compound semiconductor containing Cu, Zn, Sn and S but not containing a material including Na and O, and a photoelectric device in which the sulfide compound semiconductor is used for its light absorbing layer.

### Citation List

### Patent Literatures

Patent Document 1: Japanese Patent Application Laid-Open (JP-A) No. 2009-26891

### Summary of the Invention

### Problems to be Solved by the Invention

A conventional Cu₂ZnSnS₄ as disclosed in Patent Document 1 (hereinafter, sometimes referred to as "CZTS") has a band gap of around 1.45 eV. In order to improve conversion efficiency of the CZTS-based thin film solar cell, it is desired that the cell absorbs a wide range of wavelength of solar light to generate electricity. However, since the composition material of Cu₂ZnSnS₄ itself that has been discovered until now only has a single band gap, range of solar light to be absorbed is limited. In order to develop a CZTS-based thin film solar cell that can absorb a wide range of wavelength of solar light, it can be considered that it is effective to configure a so-called multi-junction solar cell in which a plurality of CZTS-based materials having different band gaps are laminated. However, a changing/adjusting method of band gap in the CZTS-based material has not been found out until now, and the changing/adjusting method of band gap in the CZTS-based material has not been established. For this reason, the multi-junction solar cell in which a plurality of CZTS-based materials having different band gaps could not be configured.

Accordingly, an object of the present invention is to provide a CZTS-based compound semiconductor whose band gap is different from that of a conventional CZTS-based compound semiconductor and a photoelectric conversion device prepared with the CZTS-based compound semiconductor.

### Means for Solving the Problems

The inventors of the present invention, as a result of an intensive study, have found out that it is possible to obtain a CZTS-based compound semiconductor whose band gap is different from that of a conventional CZTS by having a ratio of Cu, Zn and Sn configuring the CZTS-based compound semiconductor different from the ratio of Cu, Zn and Sn configuring the conventional Cu₂ZnSnS₄. More specifically, they have found out that it becomes possible to obtain a CZTS-based compound semiconductor whose band gap is reduced compared with the conventional CZTS by, comparing with the conventional CZTS, (1) increasing content ratio of Cu to raise the upper end of the valence band (VBM), (2) reducing content ratio of Sn to lower the lower end of the conducting band (CBM), (3) substituting Zn partially with an element having a larger ionic radius than an ionic radius of Zn, which element is to be a divalent ion (for example, Ca, Sr, Ba and the like). They also have found out that it becomes possible to obtain a CZTS-based compound semiconductor whose band gap is increased compared with the conventional CZTS by, comparing with the conventional CZTS, (4) reducing content ratio of Cu to lower the upper end of the valence band (VBM), (5) increasing content ratio of Sn to raise the lower end of the conducting band (CBM), (6) substituting Zn partially with an element having a smaller ionic radius than an ionic radius of Zn, which element is to be a divalent ion (for example, Mg, Be and the like) . The present invention has been made based on the above findings.

In order to solve above problems, the present invention takes the following means. That is, a first aspect of the present invention is a CZTS-based compound semiconductor having a larger ratio of the number of moles of Cu to the total number of moles of Cu, Zn and Sn than a ratio of the number of moles of Cu to the total number of moles of Cu, Zn and Sn configuring Cu₂ZnSnS₄. By making the ratio of the number of moles of Cu larger, it is possible to raise the upper end of the valence band (VBM), therefore it is possible to obtain a CZTS-based compound semiconductor whose band gap is reduced compared with the conventional CZTS.

Also, in the first aspect of the present invention, additionally, a ratio of the number of moles of Zn to the total number of moles of Cu, Zn and Sn can be made smaller than a ratio of the number of moles of Zn to the total number of moles of Cu, Zn and Sn configuring Cu₂ZnSnS₄. With such a configuration, it is possible to obtain a CZTS-based compound semiconductor whose band gap is reduced compared with the conventional CZTS.

A second aspect of the present invention is a CZTS compound semiconductor having a smaller ratio of the number of moles of Zn to the total number of moles of Cu, Zn and Sn than a ratio of the number of moles of Zn to the total number of moles of Cu, Zn and Sn configuring Cu₂ZnSnS₄. By making the ratio of number of moles of Zn smaller to make a ratio of the number of moles of Cu and Sn larger for example, it is possible to obtain a CZTS-based compound semiconductor whose band gap is reduced compared with the conventional CZTS.

A third aspect of the present invention is a CZTS compound semiconductor having a smaller ratio of the number of moles of Sn to the total number of moles of Cu, Zn and Sn than a ratio of the number of moles of Sn to the total number of moles of Cu, Zn and Sn configuring Cu₂ZnSnS₄. By making the ratio of the number of moles of Sn small, it is possible to lower the lower end of the conducting band (CBM), therefore it is possible to obtain a CZTS-based compound semiconductor whose band gap is reduced compared with the conventional CZTS.

A fourth aspect of the present invention is a CZTS-based compound semiconductor comprising a part of Zn configuring Cu₂ZnSnS₄, the part being substituted by an element having a larger ionic radius than an ionic radius of Zn, the element being to be a divalent ion (for instance, Ca, Sr, Ba and the like). By substituting Zn partially with Ca, Sr, Ba or the like, it is possible to obtain a CZTS-based compound semiconductor whose band gap is reduced compared with the conventional CZTS.

A fifth aspect of the present invention is a CZTS-based compound semiconductor having a smaller ratio of the number of moles of Cu to the total number of moles of Cu, Zn and Sn than a ratio of the number of moles of Cu to the total number of moles of Cu, Zn and Sn configuring Cu₂ZnSnS₄. By making the ratio of the number of moles of Cu smaller, it is possible to lower the upper end of the valence band (VBM), therefore it is possible to obtain a CZTS-based compound semiconductor whose band gap is increased compared with the conventional CZTS.

Also, in the fifth aspect of the present invention, additionally, it is preferable to make a ratio of the number of moles of Sn to the total numbers of moles of Cu, Zn and Sn larger than a ratio of the number of moles of Sn to the total number of the moles of Cu, Zn and Sn configuring Cu₂ZnSnS₄. With such a configuration, it becomes easy to obtain a CZTS-based compound semiconductor whose band gap is increased compared with the conventional CZTS.

A sixth aspect of the present invention is a CZTS-based compound semiconductor having a larger ratio of the number of moles of Sn to the total number of moles of Cu, Zn and Sn than a ratio of the number of moles of Sn to the total number of moles of Cu, Zn and Sn configuring Cu₂ZnSnS₄. By making the ratio of the number of moles of Su larger, it is possible to raise the lower end of the conducting band (CBM), therefore it is possible to obtain a CZTS-based compound semiconductor whose band gap is increased compared with the conventional CZTS.

A seventh aspect of the present invention is a CZTS-based compound semiconductor comprising a part of Zn configuring Cu₂ZnSnS₄, the part being substituted by an element having a smaller ionic radius than an ionic radius of Zn, the element being to be a divalent ion. (for example, Mg, Be and the like). By substituting Zn partially with Mg, Be or the like, it is possible to obtain a CZTS compound semiconductor whose band gap is increased compared with the conventional CZTS.

An eighth aspect of the present invention is a photoelectric conversion device comprising a plurality of CZTS-based compound semiconductors having different band gaps, wherein the CZTS-based compound semiconductor according to the first to the seventh aspects of the present invention is included in the plurality of CZTS-based compound semiconductors. With such a configuration, it is possible to configure a multi-junction solar cell in which a plurality of CZTS materials having different band gaps are laminated, therefore it is possible to provide a photoelectric conversion device that can absorb a wide range of wavelengths of solar light.

### Effects of the Invention

According to the present invention, it is possible to provide a CZTS-based compound semiconductor whose band gap is different from that of the conventional CZTS-based compound semiconductor and a manufacturing method of the CZTS-based compound semiconductor, and a photoelectric conversion device prepared with the CZTS-based compound semiconductor and a manufacturing method of the photoelectric conversion device.

### Brief Description of the Drawings

Fig. 1 is a view to describe a concept of the present invention;
Fig. 2 is a view to describe a composition of a CZTS-based compound semiconductor;
Fig. 3 is a graph showing results of X-ray diffraction of synthetic powders;
Fig. 4 is a graph showing results of X-ray diffraction of synthetic powders;
Fig. 5 is a graph showing results of optical characteristic measurement;
Fig. 6 is a graph showing results of optical characteristic measurement.

### Modes for Carrying Out the Invention

Hereinafter, the present invention will be described with reference to the drawings. It should be noted that the embodiments shown below is examples of the present invention, and the present invention is not limited to the embodiments.

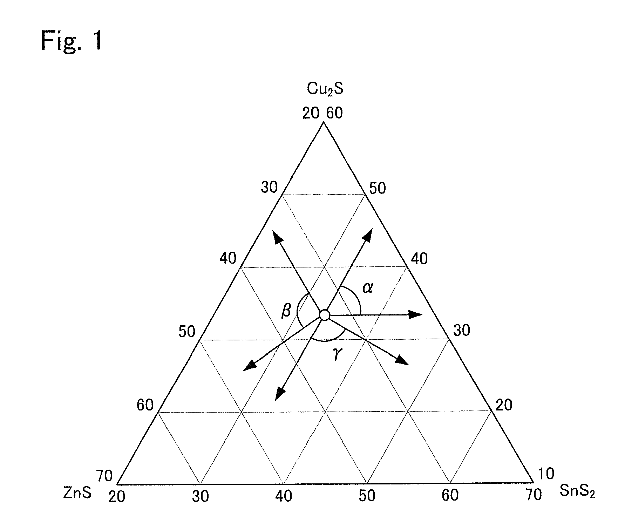

Fig. 1 is a view to describe a concept of the present invention. As described above, in the present invention, for example, by increasing content ratio of Cu to raise the upper end of the valence band (VBM) comparing with the conventional CZTS, a CZTS-based compound semiconductor whose band gap is reduced than that of the conventional CZTS is made. Such a CZTS compound semiconductor can be obtained by, for example, having the CZTS-based compound semiconductor within the area shown by α in Fig. 1.

Also, in the present invention, for instance, by reducing content ratio of Sn to lower the lower end of the conducting band (CBM) than the conventional CZTS, a CZTS-based compound semiconductor whose band gap is reduced compared with the conventional CZTS is made. Such a CZTS-based compound semiconductor can be obtained by, for example, having the CZTS-based compound semiconductor within the area shown by β in Fig. 1.

Also, in the present invention, for example, by substituting Zn partially with an element having a larger ionic radius than an ionic radius of Zn, which element is to be a divalent ion (for example, Ca, Sr, Ba and the like), a CZTS-based compound semiconductor whose band gap is reduced compared with the conventional CZTS is obtained. The reason why it is possible to reduce the band gap of the CZTS-based compound semiconductor with such a configuration is that the lattice constant of the CZTS-based compound semiconductor becomes large.

In addition, in the present invention, for example, by reducing the content ratio of Cu to lower the upper end of the valence band (VBM) comparing with the conventional CZTS, a CZTS-based compound semiconductor whose band gap is increased compared with the conventional CZTS is made. Such a CZTS-based compound semiconductor can be obtained by, for example, having the CZTS-based compound semiconductor within the area shown by γ in Fig. 1.

Also, in the present invention, for example, by increasing the content ratio of Sn comparing with the conventional CZTS to raise the lower end of the conducting band (CBM), a CZTS-based compound semiconductor whose band gap is increased compared with the conventional CZTS is made. Such a CZTS-based compound semiconductor can be obtained by, for example, having the CZTS-based compound semiconductor within the area shown by γ in Fig. 1.

Also, in the present invention, for example, by substituting Zn partially with an element having a smaller ionic radius than an ionic radius of Zn, which element is to be a divalent ion (for example, Mg, Be and the like), a CZTS-based compound semiconductor whose band gap is increased compared with the conventional CZTS is obtained. The reason why it is possible to increase the band gap of the CZTS-based compound semiconductor with such a configuration is that the lattice constant of the CZTS-based compound semiconductor becomes small.

It is possible to reach the areas shown by α, β, and γ in Fig. 1 by adequately adjusting mixing ratio of Cu₂S, ZnS and SnS₂. It is possible to produce the CZTS-based compound semiconductor of the present invention whose band gap is different from the conventional CZTS, for example, by using Cu₂S, ZnS and SnS₂ whose mixing ratio is adjusted. Methods for synthesizing a CZTS prepared with these law materials are not particularly limited, and for example, a method of: forming a sputter film of metal precursor; thereafter sulfurizing the resulting material in H₂S gas, a method of: melting sulfide powder by a solvent to print and form a film; thereafter firing and sulfurizing the resulting material in H₂S gas, a method of: mixing a sulfide powder; then synthesize the mixture to print; thereafter firing and sulfurizing the resulting material in H₂S gas, a method of: synthesizing CZTS particles by a chemical liquid-phase synthesis; after that printing and firing the resulting material to sulfurize it in H₂S gas and the like can be exemplified.

According to the present invention, since band gaps can be changed with the CZTS-related elements, by employing same manners (temperature, handling method and the like) in the producing process, it is possible to produce a plurality of CZTS-based compound semiconductors having different band gaps. Therefore, it is possible to produce a photoelectric conversion device that is stable in performance at low cost.

### Examples

Hereinafter, the present invention will be further specifically described with reference to Examples and Comparative Examples.

### 1. Production of CZTS-based Compound Semiconductor

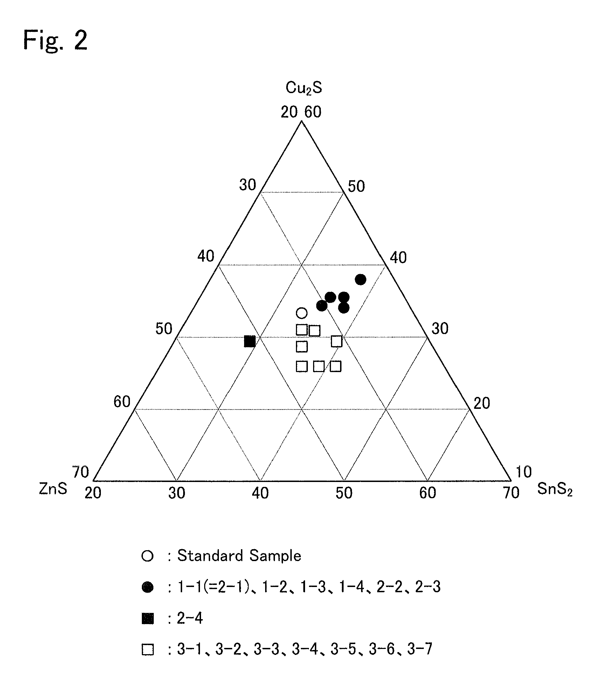

Each powder of Cu₂S (manufactured by Kojundo Chemical Laboratory Co., LTD), ZnS (manufactured by Kojundo Chemical Laboratory Co., LTD) and SnS₂ (manufactured by Kojundo Chemical Laboratory Co., LTD) was measured in a predetermined amount and put in a ball mill. Subsequently, 50 vol% of ethanol was put in the ball mill and contents of the ball mill were mixed for 24 hours. After that, the resulting material was dried at 120°C for 10 hours to obtain a powder. The obtained powder was put into a glass tube, and vacuum drawing was carried out followed by substitution by nitrogen gas. By heating and sealing the glass tube, a glass capsule was produced. Thereafter, the produced glass capsule was put in an electrical furnace (manufactured by Yamato Scientific Co. , LTD) and heating treatment was carried out at 700°C for 5 hours whereby a synthetic powder was produced. Mixing ratios of Cu₂S, ZnS and SnS₂ in cases where the total amount of Cu₂S, ZnS and SnS₂ is defined as 1 are shown in Table 1. The mixing ratios of Cu₂S, ZnS and SnS₂ in Table 1 are shown being rounded off to two decimal places, and for convenience, ratio of Cu (rate of Cu to the total amount of Cu, Zn and Sn), ratio of Zn (rate of Zn to the total amount of Cu, Zn and Sn) and ratio of Sn (rate of Sn to the total amount of Cu, Zn and Sn) are shown being rounded off to three decimal places. Mixing ratios of raw materials of each synthetic powder are also shown in Fig. 2.

**[Table 1]**

| Sample No. | Cu₂S | ZnS | SnS₂ | Ratio of Cu | Ratio of Zn | Ratio of Sn | Eg [eV] |
|---|---|---|---|---|---|---|---|
| Standard Sample | 0.33 | 0.33 | 0.33 | 0.500 | 0.250 | 0.250 | 1.46 |
| 1-1 | 0.34 | 0.31 | 0.36 | 0.504 | 0.230 | 0.267 | 1.14 |
| 1-2 | 0.36 | 0.29 | 0.36 | 0.526 | 0.212 | 0.263 | 1.12 |
| 1-3 | 0.34 | 0.28 | 0.38 | 0.507 | 0.209 | 0.284 | 1.11 |
| 1-4 | 0.38 | 0.24 | 0.38 | 0.551 | 0.174 | 0.275 | 1.09 |
| 2-1 (= 1-1) | 0.34 | 0.31 | 0.36 | 0.504 | 0.230 | 0.267 | 1.14 |
| 2-2 | 0.36 | 0.29 | 0.36 | 0.526 | 0.212 | 0.263 | 1.12 |
| 2-3 | 0.36 | 0.28 | 0.38 | 0.522 | 0.203 | 0.275 | 1.11 |
| 2-4 | 0.29 | 0.42 | 0.29 | 0.450 | 0.326 | 0.225 | 1.34 |
| 3-1 | 0.31 | 0.34 | 0.34 | 0.477 | 0.262 | 0.262 | 1.51 |
| 3-2 | 0.29 | 0.36 | 0.36 | 0.446 | 0.277 | 0.277 | 1.55 |
| 3-3 | 0.31 | 0.33 | 0.36 | 0.473 | 0.252 | 0.275 | 1.50 |
| 3-4 | 0.29 | 0.31 | 0.39 | 0.453 | 0.242 | 0.305 | 1.53 |
| 3-5 | 0.26 | 0.37 | 0.37 | 0.413 | 0.294 | 0.294 | 1.60 |
| 3-6 | 0.26 | 0.35 | 0.39 | 0.413 | 0.278 | 0.310 | 1.66 |
| 3-7 | 0.26 | 0.33 | 0.41 | 0.413 | 0.262 | 0.325 | 1.71 |

### 2. X-ray diffraction measurement

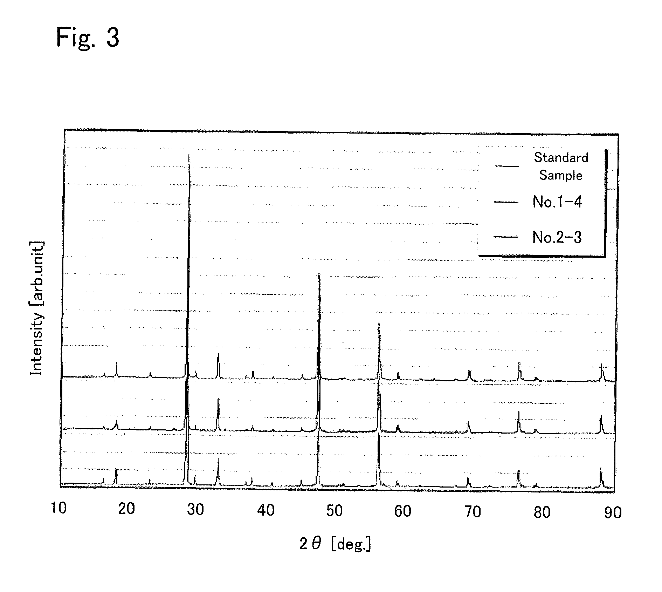

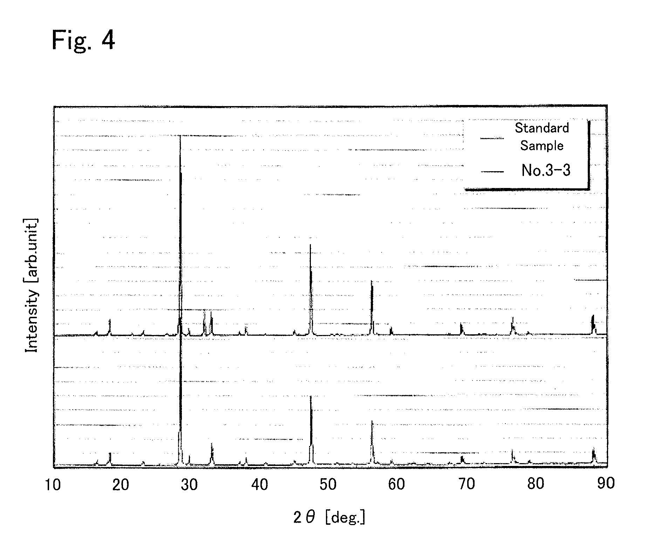

By carrying out X-ray diffraction measurement by means of a powder X-ray diffractometer (RINT2000, manufactured by Rigaku Corporation), it was confirmed that each produced synthetic powder has a single composition. Results of the X-ray diffraction of each synthetic powder of Standard sample, Sample No. 1-4, and Sample No. 2-3 are shown in Fig. 3. From upper side of plane of paper of Fig. 3, the Results of Standard sample, Sample No. 1-4, and Sample No. 2-3 are shown in the order mentioned. Also, results of the X-ray diffraction of each synthetic powder of Standard sample and Sample No. 3-3 are shown in Fig. 4. From upper side of plane of paper of Fig. 4, results of Standard Sample and Sample No. 3-3 are shown in the order mentioned. Intensity [arb.unit] is taken along the vertical axis, and 2θ [deg] is taken along the horizontal axis of each graph of the Figs. 3 and 4.

### 3. Optical characteristic measurement

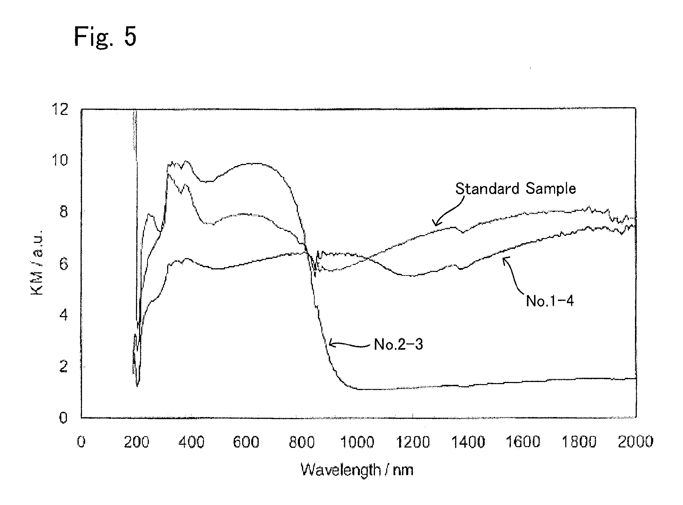

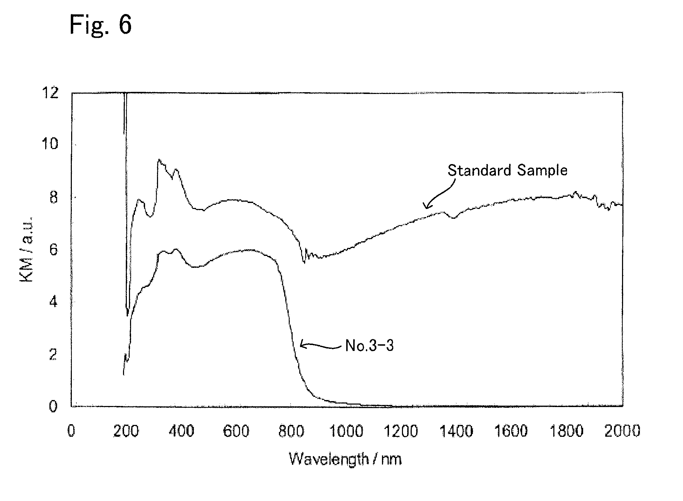

By carrying out an optical characteristic measurement by means of an ultraviolet visible near infrared spectrophotometer (LAMBDA 950, manufactured by PerkinElmer Inc.), a band gap of each of the produced synthetic powder was identified. Identified band gaps (Eg[eV]) are shown in Table 1. The band gaps Eg [eV] in Table 1 are shown being rounded off to two decimal places. Also, results of the optical characteristic measurement of each synthetic powder of Standard sample, Sample No. 1-4 and Sample No. 2-3 are shown in Fig. 5. and results of the optical characteristic measurement of each synthetic powder of Standard sample and Sample No. 3-3 are shown in Fig. 6. Intensity KM [a.u.] of light converted by Kubelka-Munk formula is taken along the vertical axis, and its wavelength [nm] is taken along the horizontal axis of the graphs of Figs. 5 and 6.

### 4. Results

As shown in Figs. 3 and 4, all the produced synthetic powder had peaks at same positions, and each had a CZTS single composition. Also, as shown in Figs. 5 and 6, each synthetic powder showed a different optical characteristic from others. It is considered that this is because the synthetic powders have different band gaps, as shown in Table 1.

By comparing Table 1 and Fig. 2 with Fig. 1, it was found out that a CZTS-based compound semiconductor in which the band gap is greatly reduced (band gap: between 1. 09 eV and 1. 14 eV inclusive) can be obtained by having the CZTS-based compound semiconductor within the area shown by α in Fig. 1. Also, it was found out that a CZTS-based compound semiconductor in which the band gap is reduced (band gap: between 1.3 eV and 1. 4 eV inclusive) can be obtained by having the CZTS-based compound semiconductor within the area shown by β in Fig. 1. It was also found out that a CZTS-based compound semiconductor whose band gap is increased (band gap: between 1.50 eV and 1.71 eV inclusive) can be obtained by having the CZTS-based compound semiconductor within the area shown by γ in Fig. 1.

As described above, according to the present invention, it is possible to provide a CZTS-based compound semiconductor whose band gap is different from that of the conventional CZTS-based compound semiconductor. Also, by employing such a CZTS-based compound semiconductor, it becomes possible to configure a multi-junction solar cell in which a plurality of CZTS-based compound semiconductors having different band gaps are layered. Therefore, according to the present invention, it is also possible to provide a photoelectric conversion device in which the conversion efficiency is improved.

## Claims

1. A CZTS-based compound semiconductor having a larger ratio of the number of moles of Cu to the total number of moles of Cu, Zn and Sn than a ratio of the number of moles of Cu to the total number of moles of Cu, Zn and Sn configuring Cu₂ZnSnS₄.

2. The CZTS-based compound semiconductor according to claim 1, wherein a ratio of the number of moles of Zn to the total number of moles of Cu, Zn and Sn is smaller than a ratio of the number of moles of Zn to the total number of moles of Cu, Zn and Sn configuring Cu₂ZnSnS₄.

3. A CZTS-based compound semiconductor having a smaller ratio of the number of moles of Zn to the total number of moles of Cu, Zn and Sn than a ratio of the number of moles of Zn to the total number of moles of Cu, Zn and Sn configuring Cu₂ZnSnS₄.

4. A CZTS-based compound semiconductor having a smaller ratio of the number of moles of Sn to the total number of moles of Cu, Zn and Sn than a ratio of the number of moles of Sn to the total number of moles of Cu, Zn and Sn configuring Cu₂ZnSnS₄.

5. A CZTS-based compound semiconductor comprising a part of Zn configuring Cu₂ZnSnS₄, the part being substituted by an element having a larger ionic radius than an ionic radius of Zn, the element being to be a divalent ion.

6. A CZTS-based compound semiconductor having a smaller ratio of the number of moles of Cu to the total number of moles of Cu, Zn and Sn than a ratio of the number of moles of Cu to the total number of moles of Cu, Zn and Sn configuring Cu₂ZnSnS₄.

7. The CZTS-based compound semiconductor according to claim 6, wherein a ratio of the number of moles of Sn to the total number of moles of Cu, Zn and Sn is larger than a ratio of the number of moles of Sn to the total number of moles of Cu, Zn and Sn configuring Cu₂ZnSnS₄.

8. A CZTS-based compound semiconductor having a larger ratio of the number of moles of Sn to the total number of moles of Cu, Zn and Sn than a ratio of the number of moles of Sn to the total number of moles of Cu, Zn and Sn configuring Cu₂ZnSnS₄.

9. A CZTS-based compound semiconductor comprising a part of Zn configuring Cu₂ZnSnS₄, the part being substituted by an element having a smaller ionic radius than an ionic radius of Zn, the element being to be a divalent ion.

10. A photoelectric conversion device comprising a plurality of CZTS-based compound semiconductors having different band gaps, wherein the CZTS-based compound semiconductor according to any one of claims 1 to 9 is included in the plurality of CZTS-based compound semiconductors.
